# EUROPEAN PATENT SPECIFICATION

(11) **EP 3 864 828 B1**
(45) Date of publication and mention of the grant of the patent: **22.11.2023**
(21) Application number: 18825600.2
(22) Date of filing: 11.12.2018
(51) Int. Cl.: H04M 1/02, H05K 5/00, H05K 5/02, H04M 1/18

(54) **CONNECTION OF HOUSING PARTS TO AN INTERNAL FRAME OF A MOBILE PHONE.**
VERBINDUNG VON GEHÄUSETEILEN MIT EINEM INNENRAHMEN EINES MOBILTELEFONS.
RACCORDEMENT DES PIÈCES DU BOÎTIER À UN CADRE INTERNE D'UN TÉLÉPHONE MOBILE.

(43) Date of publication of application: 18.08.2021
(73) Proprietor: Huawei Technologies Co., Ltd., Shenzhen, Guangdong 518129 (CN)
(72) Inventor: HEISKANEN, Juuso, 16440 Kista (SE)
(74) Representative: MERH-IP Matias Erny Reichl Hoffmann Patentanwälte PartG mbB
(86) International application number: PCT/EP2018/084369
(87) International publication number: WO 2020/119894

(56) References cited:
- CN-U- 203 260 241
- US-A1- 2010 048 147
- US-A1- 2010 248 790
- US-A1- 2014 362 548
- US-A1- 2016 036 947
- Lu Zhengang ET AL: "(PDF) Transparent multi-layer graphene/polyethylene terephthalate structures with excellent microwave absorption and electromagnetic interference shielding performance", , 26 August 2016 (2016-08-26), XP055586728, Retrieved from the Internet: URL:https://www.researchgate.net/publicati on/306924263_Transparent_multi-layer_graph enepolyethylene_terephthalate_structures_w ith_excellent_microwave_absorption_and_ele ctromagnetic_interference_shielding_perfor mance [retrieved on 2019-05-08]
- Song Wei-Li ET AL: "Magnetic and conductive graphene papers toward thin layers of effective electromagnetic shielding - Journal of Materials Chemistry A (RSC Publishing)", , 1 May 2015 (2015-05-01), XP055586749, Retrieved from the Internet: URL:https://pubs.rsc.org/en/content/articl elanding/2015/ta/c4ta05939e#|divAbstract [retrieved on 2019-05-08]

## Description

### TECHNICAL FIELD

The disclosure relates to an electronic device comprising an internal component, a frame configured for receiving the internal component, a housing comprising a display, the housing at least partially enclosing the frame and the internal component.

### BACKGROUND

United States Patent Application Publication No. US 2010/248790 A1 discloses a portable electronic apparatus. The portable telephone has a substantially planar first case, and an underside case connected to the first case through a hinge portion. The hinge portion has a fixed portion being fixed in the first case equipped with a sheet metal member having a folded portion where the end portion is folded in the thickness direction of the first case. The folded portion of the sheet metal member has screw holes and tightened to the fixed portion concurrently by means of screws inserted into the screw holes in the direction intersecting the thickness direction of the first case perpendicularly. In particular, this document describes an electronic device comprising an internal component, a frame for receiving the internal component, a housing comprising a display having an open end perpendicular to a longitudinal direction, and connection means for connecting an end cap of the housing rigidly with the frame and resiliently with the internal component. The connection means has a female and a male part.

United States Patent Application Publication No. US 2010/048147 A1 describes a boss reinforcing apparatus of a portable communication device including a press member, the boss reinforcing apparatus including at least one reinforcing part assembled with a boss that is formed on a case of the portable communication device when the case is insert-injection-molded onto the press member, to reinforce the boss and prevent a screw assembling part formed on the boss from separating from the boss.

United States Patent Application Publication No. US 2014/362548 A1 provides a chip card holder including a housing, a receiving frame, a tray, and a pin. The housing defines a latching groove. The receiving frame is mounted to the housing, and the receiving frame includes at least one ejecting arm. The tray is slidably received in the receiving frame and defines a receiving groove configured for receiving a chip card. The tray includes a latching tongue. When the tray is received in the receiving frame, the latching tongue is latched in the latching groove, and the ejecting arm abuts against one end of the tray. The pin deforms the latching tongue to unlock the tray from the housing.

The components of an electronic device such as a mobile phone are conventionally assembled by stacking them on top of each other from either the front side or the rear side of the electronic device. This assembly method, however, limits the configuration possibilities of the housing, e.g., preventing the housing from being made in one piece. A seamless, one-piece housing might be desirable for many reasons such as durability, manufacturing, and design.

By providing the internal components of the electronic device onto a frame which is slid into a housing, through an open end of the housing, and which frame is thereafter interlocked with the housing, a seamless, one-piece housing is facilitated. However, due to lack of visibility and access to components which is a result of such a one-piece housing, secure interconnection between the frame, internal components, and the housing is difficult to achieve.

Furthermore, glass material is becoming increasingly popular as housing material due to the exclusive and clean look it gives the electronic device. Glass is a fragile material which requires care to be taken during processing, preferably avoiding drilling of holes which accommodate means used for interlocking the housing and the frame. Furthermore, care should be taken not to drop the device since a glass housing is not durable enough to withstand impact.

### SUMMARY

It is an object to provide an improved electronic device with a one-piece housing. The foregoing and other objects are achieved by the features of the independent claims. Further implementation forms are apparent from the dependent claims, the description, and the figures.

According to a first aspect, there is provided an electronic device comprising an internal component, a frame configured for receiving the internal component, a housing comprising a display, the housing at least partially enclosing the frame and the internal component along a longitudinal axis of the electronic device, at least one end cap configured to engage with an open end of the housing, the open end extending substantially perpendicular to the longitudinal axis, connection means configured to connect the end cap rigidly with the frame and resiliently with the internal component, the connection means comprising a female part and a male part, the female part being arranged at least partially between the frame and the internal component in the direction of the longitudinal axis, the female part comprising a first opening, the frame comprising a second opening, and the end cap comprising a third opening, the first opening, the second opening, and the third opening being aligned and configured to receive the male part, the male part being configured to engage at least one of the first opening, the second opening, and the third opening such that the male part cannot be displaced, in relation to the frame, along the longitudinal axis, the female part comprising at least one tongue configured to engage with a surface of the internal component, such that the internal component can be displaced in relation to the frame in at least a direction perpendicular to the longitudinal axis.

Such a solution allows for an electronic device provided with a housing which encloses at least a large part of the internal components of the device, which internal components can still be easily assembled within the housing. Furthermore, the solution provides a durable electronic device, which provides protection for the ends of the housing as well as interconnects the external components of the device securely, such that the device can withstand the forces applied onto it e.g. when dropping the device.

In a possible implementation form of the first aspect, the electronic device further comprises two end caps, each end cap being configured to engage one of two open ends of the housing, the end cap having a first peripheral shape corresponding to an outer boundary of the housing, the end cap having a second peripheral shape corresponding to an inner boundary of the housing, allowing a secure interconnection between housing and end caps as well as preventing end caps from being accidentally pushed into the housing and damaging internal components.

The end cap comprises an antenna part and a nonconductive part, the nonconductive part separating the antenna part from the frame, the connection means being conductive and extending from the antenna part to the internal component, facilitating an electronic device provided with sufficient antenna means.

In a further possible implementation form of the first aspect, the electronic device comprises insulating means at least partially enclosing the connection means, insulating the connection means from the frame, allowing conventional, conductive materials to be used for connection means and frame.

In a further possible implementation form of the first aspect, the male part is a screw and the first opening of the female part comprises a corresponding thread, facilitating simple, reusable, and reliable connection between the end cap and the rest of the device.

In a further possible implementation form of the first aspect, the electronic device further comprises fixation means for fixing the internal component rigidly to the frame, maintaining the internal component securely within the frame and allowing easy assembly of the electronic device.

In a further possible implementation form of the first aspect, the female part comprises a block shaped section and a sheet shaped section, the first opening extending at least through the block shaped section, the tongue extending from the sheet shaped section, facilitating connection means which are stable and easy to use, yet flexible.

In a further possible implementation form of the first aspect, the block shaped section protrudes from a surface of the sheet shaped section, the sheet shaped section being curved to partially enclose the block shaped section in a direction perpendicular to a center axis of the first opening, the at least one tongue extending from an edge of the sheet shaped section, in a plane parallel with the center axis, and the at least one tongue being configured to abut a first surface of the interior component, providing a connection means which is fixedly connected to the internal component while still resilient enough to facilitate assembly of the electronic device.

In a further possible implementation form of the first aspect, the sheet shaped section comprises two tongues extending on opposite sides of the first opening in a direction away from the first opening, allowing the connection means to carry load evenly.

In a further possible implementation form of the first aspect, the block shaped section protrudes from a surface of the sheet shaped section, the tongue extending from an edge of the sheet shaped section adjacent a side wall of the block shaped section, the side wall extending perpendicular to the surface if the sheet shaped section, the tongue being configured to abut a second surface of the interior component, facilitating connection means which are stable and easy to use, yet flexible.

In a further possible implementation form of the first aspect, the electronic device comprises locking means configured to prevent the female part from rotating in relation to the frame, in response to rotation of the male part.

In a further possible implementation form of the first aspect, the locking means comprises a locking protrusion, extending from at least one of the female part and the insulating means, in the direction of the center axis of the first opening, into the second opening of the frame, the locking protrusion having a peripheral shape at least partially corresponding to the shape of the second opening, eliminating the need for additional, external locking means.

In a further possible implementation form of the first aspect, the locking means comprises an adhesive, the adhesive fixedly connecting the locking protrusion to the second opening and/or the sheet shaped section of the female part to a surface of the frame.

According to a second aspect, there is provided a method of assembling an electronic device comprising an internal component, a frame configured for receiving the internal component, a housing comprising a display, the housing being configured to at least partially enclose the frame and the internal component, and at least one end cap configured to engage with an open end of the housing, the method comprising the steps of fitting a female part of at least one connection means into a recess in a first edge of the internal component, and placing and fixing protruding tongues of the female part onto a surface, adjacent the recess, of the internal component, placing the internal component in the frame, such that a first opening of the female part aligns with a second opening in the frame, fixing the internal component to the frame by fixation means, inserting the frame into the housing through a first open end of the housing, placing a first end cap at the first open end, or an opposite second open end, of the housing, such that a third opening of the end cap aligns with the first opening and the second opening, inserting a male part of the connection means successively into the third opening, the second opening, and the first opening, the male part interlocking with the first opening such that the first end cap is fixedly connected to the frame.

Such a method allows easy assembly of an electronic device provided with a housing which encloses at least a large part of the internal components of the device. Furthermore, the assembly method results in a durable electronic device, which provides protection for the ends of the housing as well as interconnects the external components of the device securely, such that the device can withstand the forces applied onto it e.g. when dropping the device.

In a possible implementation form of the second aspect, the method further comprises the steps of fitting a female part of at least one further connection means into a recess in a second edge of the internal component, prior to placing the internal component in the frame, such that a first opening of the female part aligns with a second opening in the frame, placing a second end cap at the second open end or the first open end of the housing, such that a third opening of the second end cap aligns with the first opening and the second opening, inserting a male part of the connection means successively into the third opening, the second opening, and the first opening, the male part interlocking with the first opening such that the second end cap is fixedly connected to the frame.

According to a third aspect, there is provided a method of assembling an electronic device comprising an internal component, a frame configured for receiving the internal component, a housing comprising a display, the housing being configured to at least partially enclose the frame and the internal component, and at least one end cap configured to engage with an open end of the housing, the method comprising the steps of connecting a female part of at least one connection means to a first surface of the frame, placing the internal component in the frame, adjacent the first surface of the frame, by placing a surface of the internal component onto a protruding tongue of the female part, such that a first opening of the female part aligns with a second opening in the frame, inserting the frame into the housing through a first open end of the housing, placing a first end cap at the first open end, or an opposite second open end, of the housing, such that a third opening of the end cap aligns with the first opening and the second opening, inserting a male part of the connection means successively into the third opening, the second opening, and the first opening, the male part interlocking with the first opening such that the first end cap is fixedly connected to the frame.

Such a method allows easy assembly of an electronic device provided with a housing which encloses at least a large part of the internal components of the device. Furthermore, the assembly method results in a durable electronic device, which provides protection for the ends of the housing as well as interconnects the external components of the device securely, such that the device can withstand the forces applied onto it e.g. when dropping the device.

In a possible implementation form of the third aspect, the method further comprises the steps of connecting a female part of at least one further connection means to a second surface of the frame, arranged opposite to the first surface, prior to placing the internal component in the frame, such that a first opening of the female part aligns with a second opening in the frame, placing a second end cap at the second open end or the first open end of the housing, such that a third opening of the second end cap aligns with the first opening and the second opening, inserting a male part of the connection means successively into the third opening, the second opening, and the first opening, the male part interlocking with the first opening such that the second end cap is fixedly connected to the frame.

This and other aspects will be apparent from and the embodiments described below.

### BRIEF DESCRIPTION OF THE DRAWINGS

In the following detailed portion of the present disclosure, the aspects, embodiments and implementations will be explained in more detail with reference to the example embodiments shown in the drawings, in which:
Fig. 1a shows a schematic perspective view of an electronic device in accordance with one embodiment of the present invention;
Fig. 1b shows the embodiment of Fig. 1a in exploded perspective view;
Figs. 2a and 2b show partial, exploded perspective views of the embodiment shown in Figs. 1a and 1b;
Fig. 2c shows a cross-sectional view of an electronic device in accordance with the embodiment shown in Figs. 1a to 2b;
Fig. 3a shows a partial, cross-sectional perspective view of one end of the embodiment shown in Figs. 1a to 3a;
Fig. 3b shows the embodiment in Fig. 3a in partial, cross-sectional side view;
Fig. 3c shows a partial, cross-sectional side view of an end of a further embodiment;
Fig. 4a shows a partial, cross-sectional perspective view of a part of an electronic device in accordance with one embodiment of the present invention;
Fig. 4b shows the embodiment in Fig. 4a in partial, perspective view;
Fig. 4c shows a partial, exploded perspective view of a further embodiment comprising a split antenna;
Figs. 5a and 5b show perspective views of a female part of a connection means in accordance with one embodiment of the present invention;
Fig. 5c shown a perspective view of a frame in accordance with one embodiment of the present invention;
Fig. 5d shows a perspective partial view of the embodiments in Figs. 5a to 5c;
Figs. 6a and 6b show perspective views of a female part of a connection means in accordance with a further embodiment of the present invention;
Fig. 6c shows the embodiment in Fig. 6b and a frame in accordance with one embodiment of the present invention.

### DETAILED DESCRIPTION

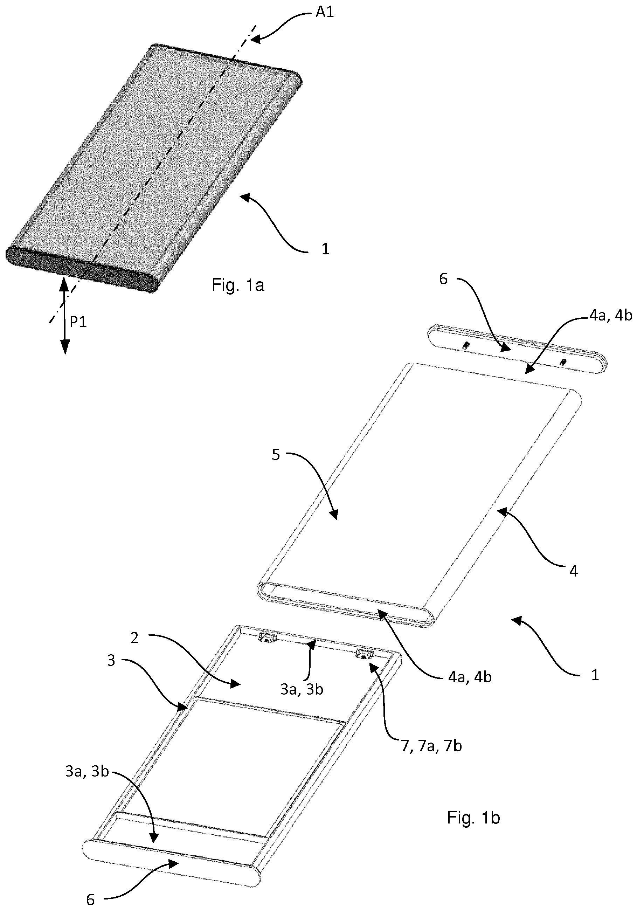

Figs. 1a and 1b show an electronic device 1, such as a mobile phone or a tablet, which comprises an internal component 2, a frame 3 configured for receiving the internal component 2, and a housing 4. The electronic device comprises a plurality of internal components 2 such as a printed wiring board, a battery, or a camera, however, the internal component 2 referred to below is preferably a printed wiring board. The housing 4 is arranged such that it encloses the frame 3 and the internal component 2, at least partially, along the longitudinal axis A1 of the electronic device 1. In one embodiment, the electronic device 1 comprises fixation means 17 for fixing the internal component 2 rigidly to the frame 3. The fixation means 17 may, e.g., comprise of a ledge protruding from an inner surface of the frame 3, a threaded hole extending through the frame and interconnecting with a screw, a snap hook, a spring hook, or a rivet.

The housing 4 is preferably tubular and formed as a 360° closed tube around the longitudinal axis A1 of the electronic device 1. The closed wall of the housing extends between two opposite ends 4a, 4b, at least one of the ends 4a, 4b being open. The planes of the ends 4a, 4b extend substantially at a perpendicular angle to the longitudinal axis A1 of the electronic device 1, however, other angles are possible. The housing 4 may comprise of one or several of glass, metal, ceramic, plastic, and/or a composite material. In one embodiment, the housing 4 comprises of glass material only. In a further embodiment, the housing 4 essentially comprises of glass, however, the housing wall is cut through by a slit extending in a direction parallel with the longitudinal axis A1 of the electronic device 1, the void formed by the slit being filled with a material such as metal, ceramic, plastic, and/or composite, such that the glass housing and slit material together form a 360° closed tube.

The housing 4 comprises a display 5, extending at least partially over one of the two main surfaces of the electronic device 1. Preferably, the display 5 also extends over a side edge of the electronic device 1, which side edge connects the two main surfaces of the electronic device 1, and least partially over the other main surface of the electronic device 1 such that the display 5 essentially wraps around the frame 3 and the internal component 2. In one embodiment, the display extends over both main surfaces and one side edge surface, such that the display 5 forms a tube having a throughgoing slit in its wall in the direction of the longitudinal axis A1 of the electronic device 1, i.e. the cross-section of the display 5 is C-shaped. In a further embodiment, the display 5 forms a closed wall tube, extending a full 360° around the longitudinal axis A1 of the electronic device 1, i.e. the cross-section of the display 5 is O-shaped.

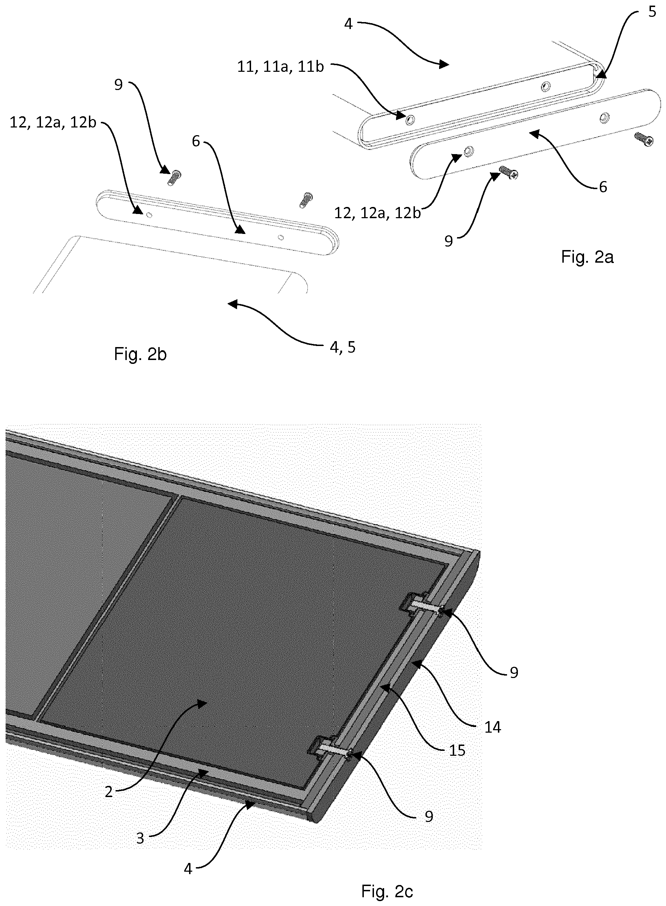

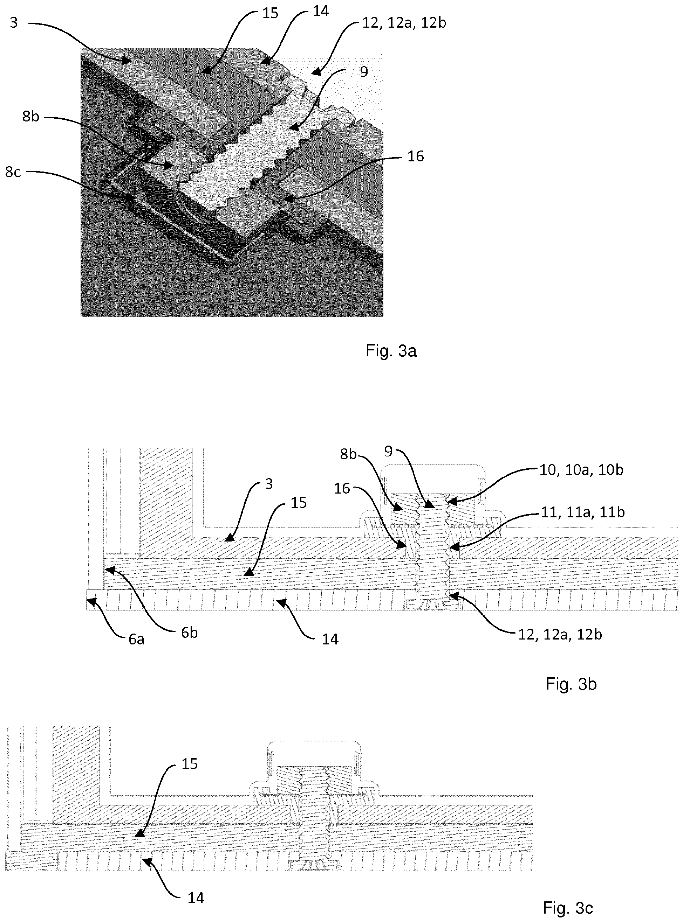

At least one end cap 6, as shown in Figs. 2a and 2b, is configured to engage with the open ends 4a, 4b of the housing 4. As shown in Fig. 1b, one end cap 6 may be attached to the frame 3, while the other end cap 6 is a separate component to be attached to the frame 3 during assembly of the electronic device 1. In a further embodiment, both end caps 6 are separate components configured to engage one of the two open ends 4a, 4b of the housing 4. Each end cap 6 may have a first peripheral shape 6a corresponding to an outer boundary of the housing 4, and a second peripheral shape 6b corresponding to an inner boundary of the housing 4, as shown in Figs. 2b and 3b. In particular Fig. 3b shows the first peripheral shape 6a of the end cap 6 corresponding to an outer boundary of the housing 4, i.e. the end cap 6 and the housing 4 having essentially the same outer dimensions in a plane perpendicular to the longitudinal axis A1 of the electronic device 1. Fig. 3b also shows the second peripheral shape 6b of the end cap 6 corresponding to an inner boundary of the housing 4, i.e. the end cap 6 has a section essentially corresponding to the inner dimensions of the housing 4 in a plane perpendicular the longitudinal axis A1 of the electronic device 1. Such a stepped configuration allows the second peripheral shape 6b of the end cap 6 to be inserted into the interior of the housing 4, while preventing the first peripheral shape 6a of the end cap 6 from being pushed into the housing 4 since a surface of the end cap 6 abuts a surface of the open end 4a, 4b.

Connection means 7, shown in more detail in Figs. 3a to 5b and 6a to 6c, are configured to connect the end cap 6 rigidly with the frame 3 and resiliently with the internal component 2. The connection means 7 comprises a female part 8 and a male part 9, the male part 9 to be partially inserted into a first opening 10 in the female part 9. In one embodiment, the male part 9 is a screw and the first opening 10 of the female part 8 comprises a corresponding thread.

The female part 8 is arranged at least partially between the frame 3 and the internal component 2 in the direction of the longitudinal axis A1 of the electronic device 1, as shown in Fig. 2c. The female part 8 comprises a first opening 10, the frame 3 comprises a second opening 11, and the end cap 6 comprises a third opening 12, which openings are aligned during assembly and all configured to receive the male part 9. The male part 9 engages at least one of the first opening 10, the second opening 11, and the third opening 12 such that the male part 9 cannot be displaced, in relation to the frame 3, along the longitudinal axis A1 of the electronic device 1, i.e. the male part 9 is prevented from unintentionally dislodging from the female part 8, the frame 3, and/or the end cap 6, and hence preventing the end cap 6 from dislodging from the housing 4 and any internal components from falling out from the housing 4.

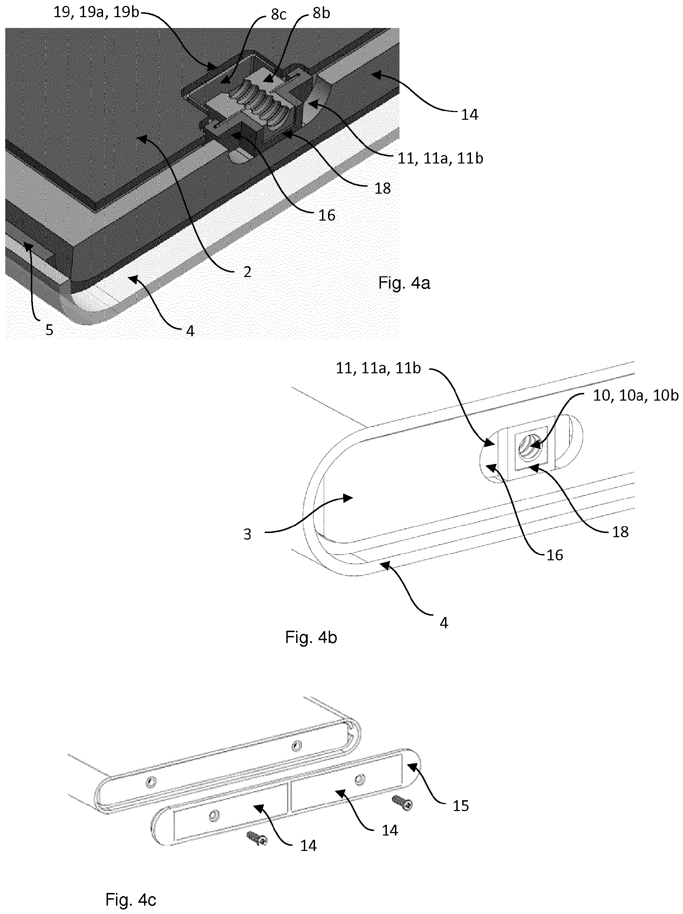

According to the invention, at least one of the end caps 6 comprises an antenna part 14 and a nonconductive part 15, the nonconductive part 15 being arranged such that it separates the antenna part 14 from the frame 3 and insulates the frame electrically from the antenna. The non-conductive part may comprise of ceramic, plastic, and/or composite material. The connection means 7 are conductive, e.g. made of metal, and extend from the antenna part 14 to the internal component 2, preferably a printed wiring board, which allows signals to be transmitted between antenna part 14 and the internal component 2. The antenna part 14 may correspond to the section of the end cap 6 having the first peripheral shape 6a, and the nonconductive part 15 corresponds to the section of the end cap 6 having the second peripheral shape 6b., as shown in Fig. 3b. The antenna part 14 may also be recessed into the nonconductive part 15 as shown in Fig. 3c. The antenna part 14 may comprise of one integral antenna part or be split into several antenna parts, as shown in Fig 4c.

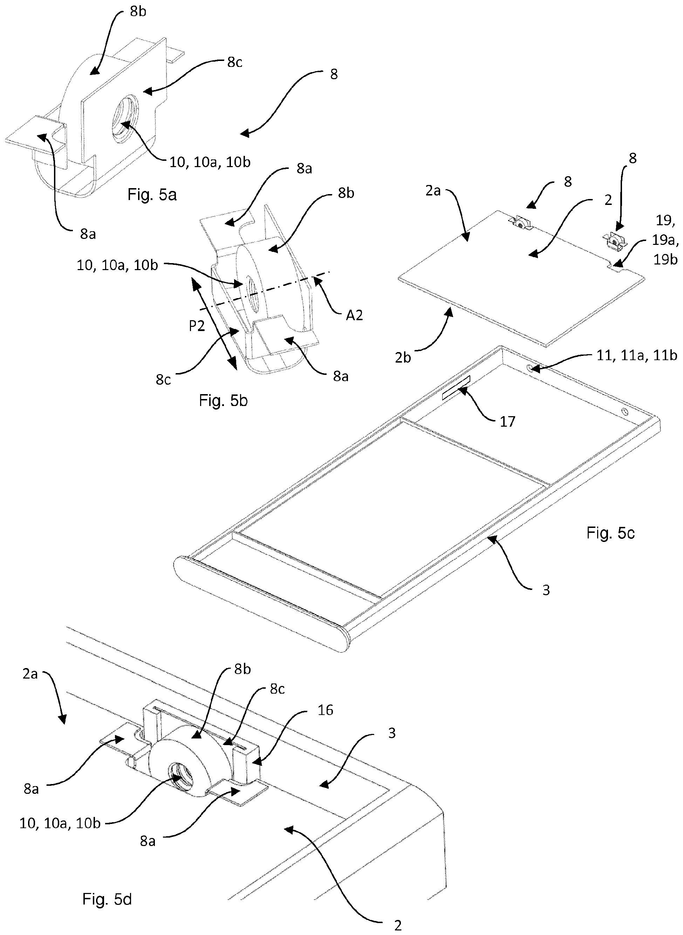

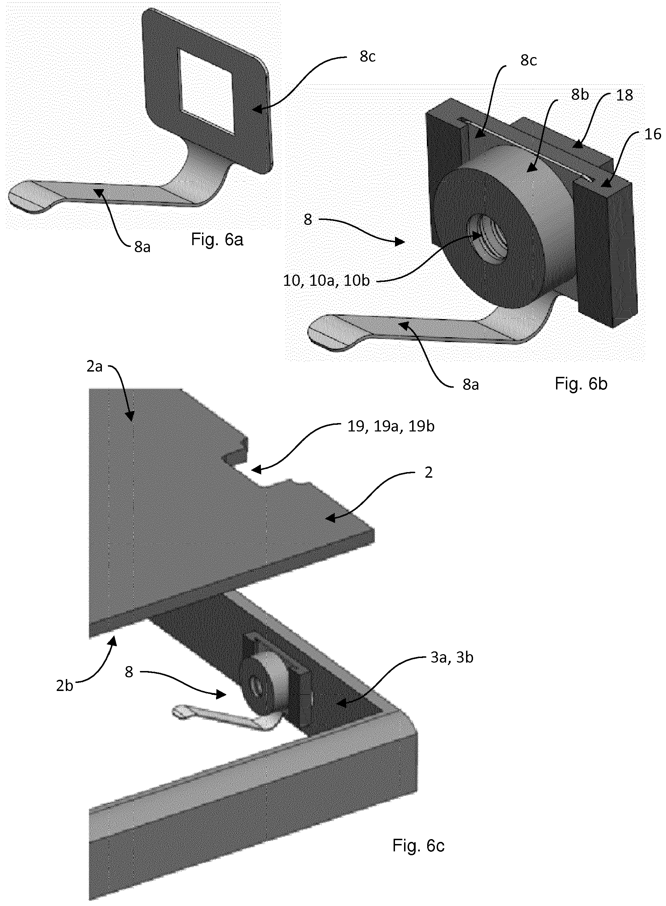

The female part 8 may comprise a block shaped section 8b and a sheet shaped section 8c, the first opening 10 extending at least through the block shaped section 8b, but preferably through both the block shaped section 8b and the sheet shaped section 8c as shown in Figs. 5a, 5b, and 6b. The block shaped section 8b reinforces the female part 8 and allows the first opening 10 to be longer and stronger, compared to a female part 8 not having such a block shaped section 8b. The block shaped section 8b protrudes from a surface of the sheet shaped section 8c, and at least one tongue 8a extends from the sheet shaped section 8c.

In one embodiment, the sheet shaped section 8c is curved to partially enclose the block shaped section 8b in a direction P2 perpendicular to a center axis A2 of the first opening 10, as shown in Figs. 5a to 5d, the center axis A2 of the first opening 10 extending in parallel with the longitudinal axis A1 of the electronic device 1. At least one tongue 8a extends from the edge of the sheet shaped section 8clocated the farthest from the block shaped section 8b. The tongue 8a extends in a plane parallel with the center axis A2 and is configured to abut a first surface 2a of the interior component 2, when fitted to the interior component 2. In one embodiment, the sheet shaped section 8c comprises two tongues 8a extending on opposite sides of the first opening 10 in a direction away from the first opening 10, in parallel with direction P2, and in a plane parallel with the center axis A2.

The tongues 8a may be essentially rigid and welded or soldered to the first surface 2a of the internal component 2. The curved section of the sheet shaped section 8c provides a certain degree of resilience to the female part 8, and hence allows a resilient connection between the end cap 6 and the internal component 2. As a result, the end cap 6 can be somewhat displaced in relation to the internal component 2 at least in a direction P1 perpendicular to the longitudinal axis A1 and to direction P2, facilitating the assembly of the electronic device. The end cap 6 is also displaceable in direction P2 and a direction P3 perpendicular directions P1 and P2. Fixation means 17 are preferably provided in order to fix the internal component 2 rigidly to the frame 3, e.g. by means of threaded holes in the frame 3 and corresponding screws.

In a further embodiment, one tongue 8a extends from an edge of the sheet shaped section 8c adjacent a side wall of the block shaped section 8b, the side wall extending perpendicular to the sheet shaped section 8c as shown in Figs. 6a to 6c. The tongue 8a is configured to abut a second surface 2b of the interior component 2, and provides a certain degree of resilience to the female part 8, allowing a resilient connection between the end cap 6 and the internal component 2. As a result, the interior component 2 can be somewhat displaced in relation to the frame 3 in direction P1 perpendicular to the longitudinal axis A1 and to direction P2, facilitating the assembly of the electronic device. The interior component 2 is also displaceable in direction P2 and direction P3. The sheet shaped section 8c of the female part 8 is fixed rigidly to the frame 3, directly or indirectly, by means of, e.g., adhesive or double-sided tape. If the sheet shaped section 8c is fixed directly to the frame 3, the adhesive layer has to be thick and electrically insulating.

In one embodiment, the connection means 7 are at least partially enclosed by insulating means 16, electrically insulating the connection means 7 from the frame 3 as shown in Figs. 3a to 4a. The insulating means 16 may, e.g., be made of plastic material. The insulating means 16 may be a separate component, or molded over the sheet shaped section 8c of the female part 8. The sheet shaped section 8c of the female part 8 is, hence, fixed indirectly to the frame 3, by means of, e.g., adhesive or press fit.

As shown in Figs. 4a and 4b, the female part 8 and/or the insulating means 16 may be provided with locking means 18 preventing the female part 8 from rotating in relation to the frame 3, e.g. in response to rotation of the male part 9. The locking means 18 comprises a locking protrusion, extending from at least one of the female part 8 and the insulating means 16, in the direction of the center axis A2, into the second opening 11 of the frame 3. Hence, the locking protrusion extends from the female part 8 from a surface of the sheet shaped section 8c opposite to the surface from which the block shaped section 8b protrudes. A locking protrusion, formed by the insulating means 16, surrounds a locking protrusion formed by the female part 8. The locking protrusion 18 has an outer peripheral shape, e.g. rectangular, which at least partially corresponds to the shape of the second opening 11, which e.g., is oblong, such that the female part and/or the insulating means 16 cannot turn within the second opening 11.

In one embodiment, the locking means 18 comprises an adhesive which connects the locking protrusion fixedly to the second opening 11. A thick layer of electrically insulating adhesive, or double-sided tape, may also be used to connect the sheet shaped section 8c of the female part 8 to an inner surface 3a, 3b of the frame.

The present disclosure further relates to a method of assembling the above described electronic device 1 comprising an internal component 2, a frame 3 configured for receiving the internal component 2, and a housing 4 comprising a display 5. The connection means 7, used to connect the frame 3 to the end cap 6, comprises a female part 8 having at least two protruding tongues 8a, as shown in Figs. 5a to 5d. The method comprises a plurality of subsequent steps described below.

Firstly, a female part 8 of at least one connection means 7a is fitted into a recess 19a in a first edge of the internal component 2, such that the protruding tongues 8a of the female part 8 are placed and fixed onto the surface 2a of the internal component 2, adjacent the recess 19a, as shown in Fig. 5c.

The method may also comprise the step of fitting a further female part 8 of at least one further connection means 7b into a further recess 19b in a second edge of the internal component 2, in a manner corresponding to that described above.

Subsequently, the internal component 2 is placed in the frame 3, such that a first opening 10a of the female part 8 of connection means 7a aligns with a second opening 11a in the frame 3, and optionally a first opening 10b of the female part 8 of connection means 7b aligns with a second opening 11b in the frame 3, as shown in Fig. 5d.

The internal component 2 is fixed to the frame 3 by fixation means 17, as shown in Fig 5c.

The frame 3 is inserted into the housing 4 through a first open end 4a of the housing 4, and a first end cap 6 is placed at the first open end 4a, or an opposite second open end 4b, of the housing 4, such that a third opening 12a of the end cap 6 aligns with the first opening 10a and the second 11a opening, as indicated in Fig. 1b.

The male part 9 of the connection means 7a is successively inserted into the third opening 12a, the second opening 11a, and the first opening 10a, the male part 9 interlocking with the first opening 10a such that the first end cap 6 is fixedly connected to the frame 3, as shown in Figs. 2c to 3b.

The method may further comprise the steps of placing a second end cap 6 at the second open end 4b or the first open end 4a of the housing 4, such that a third opening 12b of the second end cap 6 aligns with the first opening 10b and the second opening 11b, and inserting a male part 9 of the connection means 7b successively into the third opening 12b, the second opening 11b, and the first opening 10b, the male part 9 interlocking with the first opening 10b such that the second end cap 6 is fixedly connected to the frame 3.

The present disclosure further relates to a method of assembling the above described electronic device 1 comprising an internal component 2, a frame 3 configured for receiving the internal component 2, and a housing 4 comprising a display 5. The connection means 7, used to connect the frame 3 to the end cap 6, comprises a female part 8 having a protruding tongue 8a, as shown in Figs. 6a to 6c. The method comprises a plurality of subsequent steps described below.

Firstly, a female part 8 of at least one connection means 7a is connected to a first surface 3a of the frame 3, as shown in Fig. 6c, by means of e.g. adhesive.

The method may also comprise the step of connecting a further female part 8 of at least one further connection means 7b to a second surface 3b of the frame 3, arranged opposite to the first surface 3a.

Subsequently, the internal component 2 is placed in the frame 3, adjacent the first surface 3a and the second surface 3b of the frame 3, by placing the internal component 2 onto the protruding tongue(s) 8a of the female part(s) 8, such that a first opening 10a of the female part 8 of connection means 7a aligns with a second opening 11a in the frame 3, and optionally a first opening 10b of the female part 8 of connection means 7b aligns with a second opening 11b in the frame 3, as shown in Fig. 6c.

The frame 3 is inserted into the housing 4 through a first open end 4a of the housing 4, and a first end cap 6 is placed at the first open end 4a, or an opposite second open end 4b, of the housing 4, such that a third opening 12a of the end cap 6 aligns with the first 10a and second 11a openings, as indicated in Fig. 1b.

The male part 9 of the connection means 7a is successively inserted into the third opening 12a, the second opening 11a, and the first opening 10a, the male part 9 interlocking with the first opening 10a such that the first end cap 6 is fixedly connected to the frame 3, as shown in Figs. 2c to 3b.

The method may further comprise the steps of placing a second end cap 6 at the second open end 4b or the first open end 4a of the housing 4, such that a third opening 12b of the second end cap 6 aligns with the first opening 10b and the second opening 11b, and inserting a male part 9 of the connection means 7b successively into the third opening 12b, the second opening 11b, and the first opening 10b, the male part 9 interlocking with the first opening 10b such that the second end cap 6 is fixedly connected to the frame 3.

The various aspects and implementations has been described in conjunction with various embodiments herein. In the claims, the word "comprising" does not exclude other elements or steps, and the indefinite article "a" or "an" does not exclude a plurality.

The reference signs used in the claims shall not be construed as limiting the scope.

## Claims

1. An electronic device (1) comprising
an internal component (2),
a frame (3) configured for receiving said internal component (2),
a housing (4) comprising a display (5), said housing (4) at least partially enclosing said frame (3) and said internal component (2) along a longitudinal axis (A1) of said electronic device (1),
at least one end cap (6) configured to engage with an open end (4a, 4b) of said housing (4), said open end (4a, 4b) extending perpendicular to said longitudinal axis (A1),
connection means (7) configured to connect said end cap (6) rigidly with said frame (3) and resiliently with said internal component (2),
said connection means (7) comprising a female part (8) and a male part (9),
said female part (8) being arranged at least partially between said frame (3) and said internal component (2) in the direction of said longitudinal axis (A1),
said female part (8) comprising a first opening (10), said frame (3) comprising a second opening (11), and said end cap (6) comprising a third opening (12), said first opening (10), said second opening (11), and said third opening (12) being aligned and configured to receive said male part (9),
said male part (9) being configured to engage at least one of said first opening (10), said second opening (11), and said third opening (12) wherein said male part (9) is fixed in position, in relation to said frame (3), along said longitudinal axis (A1),
said female part (8) comprising at least one tongue (8a) configured to engage with a surface of said internal component (2), wherein said internal component (2) is displaceable in relation to said frame (3) in at least a direction (P1) perpendicular to said longitudinal axis (A1),
said end cap (6) comprising an antenna part (14) and a nonconductive part (15), said nonconductive part (15) separating said antenna part (14) from said frame (3),
said connection means (7) being conductive and extending from said antenna part (14) to said internal component (2).

2. The electronic device (1) according to claim 1, comprising two end caps (6), each end cap (6) being configured to engage one of two open ends (4a, 4b) of said housing (4),
said end cap (6) having a first peripheral shape (6a) corresponding to an outer boundary of said housing (4),
said end cap (6) having a second peripheral shape (6b) corresponding to an inner boundary of said housing (4).

3. The electronic device (1) according to claim 1 or 2, further comprising insulating means (16) at least partially enclosing said connection means (7), insulating said connection means (7) from said frame (3).

4. The electronic device (1) according to any one of the previous claims, wherein said male part (9) is a screw and said first opening (10) of said female part (8) comprises a corresponding thread.

5. The electronic device (1) according to any one of the previous claims, wherein said device further comprises fixation means (17) for fixing said internal component (2) rigidly to said frame (3).

6. The electronic device (1) according to any one of the previous claims, wherein said female part (8) comprises a block shaped section (8b) and a sheet shaped section (8c), said first opening (10) extending at least through said block shaped section (8b), said tongue (8a) extending from said sheet shaped section (8c).

7. The electronic device (1) according to claim 6,
wherein said block shaped section (8b) protrudes from a surface of said sheet shaped section (8c), said sheet shaped section (8c) being curved to partially enclose said block shaped section (8b) in a direction (P2) perpendicular to a center axis (A2) of said first opening (10),
said at least one tongue (8a) extending from an edge of said sheet shaped section (8c), in a plane parallel with said center axis (A2), and said at least one tongue (8a) being configured to abut a first surface (2a) of said interior component (2).

8. The electronic device (1) according to claim 7, wherein said sheet shaped section (8c) comprises two tongues (8a) extending on opposite sides of said first opening (10) in a direction away from said first opening (10).

9. The electronic device (1) according to claim 8,
wherein said block shaped section (8b) protrudes from a surface of said sheet shaped section (8c), said tongue (8a) extending from an edge of said sheet shaped section (8c) adjacent a side wall of said block shaped section (8b),
said side wall extending perpendicular to said surface of said sheet shaped section (8c), said tongue (8a) being configured to abut a second surface (2b) of said interior component (2).

10. The electronic device (1) according to any one of said previous claims, further comprising locking means (18) configured to prevent said female part (8) from rotating in relation to said frame (3), in response to rotation of said male part (9).

11. The electronic device (1) according to claim 10,
wherein said locking means (18) comprises a locking protrusion, extending from at least one of said female part (8) and said insulating means (16), in the direction of the center axis (A2) of said first opening (10), into said second opening (11) of said frame (3),
said locking protrusion (18) having a peripheral shape at least partially corresponding to the shape of said second opening (11).

12. The electronic device (1) according to claim 10 or 11,
wherein said locking means (18) comprises an adhesive, said adhesive fixedly connecting said locking protrusion to said second opening (11) and/or
said sheet shaped section (8c) of said female part (8) to a surface (3a, 3b) of said frame (3).

13. Method of assembling an electronic device (1) comprising an internal component (2),
a frame (3) configured for receiving said internal component (2),
a housing (4) comprising a display (5), said housing (4) being configured to at least partially enclose said frame (3) and said internal component (2), and at least one end cap (6) configured to engage with an open end (4a, 4b) of said housing (4),
said method comprising the steps of:
fitting a female part (8) of at least one connection means (7a) into a recess (19a) in a first edge of said internal component (2), and placing and fixing protruding tongues (8a) of said female part (8) onto a surface (2a), adjacent said recess (19a), of said internal component (2),
placing said internal component (2) in said frame (3), such that a first opening (10a) of said female part (8) aligns with a second opening (11a) in said frame (3),
fixing said internal component (2) to said frame (3) by fixation means (17),
inserting said frame (3) into said housing (4) through a first open end (4a) of said housing (4),
placing a first end cap (6) at said first open end (4a), or an opposite second open end (4b), of said housing (4), such that a third opening (12a) of said end cap (6) aligns with said first opening (10a) and said second opening (11a),
inserting a male part (9) of said connection means (7a) successively into said third opening (12a), said second opening (11a), and said first opening (10a), said male part (9) interlocking with said first opening (10a) such that said first end cap (6) is fixedly connected to said frame (3),
said end cap (6) comprising an antenna part (14) and a nonconductive part (15), said nonconductive part (15) separating said antenna part (14) from said frame (3),
said connection means (7) being conductive and extending from said antenna part (14) to said internal component (2).

14. Method according to claim 13, further comprising the steps of:
fitting a female part (8) of at least one further connection means (7b) into a recess (19b) in a second edge of said internal component (2), prior to placing said internal component (2) in said frame (3), such that a first opening (10b) of said female part (8) aligns with a second opening (11b) in said frame (3),
placing a second end cap (6) at said second open end (4b) or said first open end (4a) of said housing (4), such that a third opening (12b) of said second end cap (6) aligns with said first opening (10b) and said second opening (11b),
inserting a male part (9) of said connection means (7b) successively into said third opening (12b), said second opening (11b), and said first opening (10b), said male part (9) interlocking with said first opening (10b) such that said second end cap (6) is fixedly connected to said frame (3).

## Patentansprüche

1. Elektronische Vorrichtung (1), die Folgendes umfasst
eine interne Komponente (2),
einen Rahmen (3), der zum Aufnehmen der internen Komponente (2) konfiguriert ist,
ein Gehäuse (4), das eine Anzeige (5) umfasst, wobei das Gehäuse (4) den Rahmen (3) und die interne Komponente (2) entlang einer Längsachse (A1) der elektronischen Vorrichtung (1) mindestens teilweise umschließt,
mindestens eine Endkappe (6), die konfiguriert ist, um mit einem offenen Ende (4a, 4b) des Gehäuses (4) in Eingriff zu kommen, wobei sich das offene Ende (4a, 4b) zu der Längsachse (A1) senkrecht erstreckt,
Verbindungsmittel (7), die konfiguriert sind, um die Endkappe (6) starr mit dem Rahmen (3) und elastisch mit der internen Komponente (2) zu verbinden,
wobei das Verbindungsmittel (7) ein Buchsenteil (8) und ein Steckteil (9) umfasst,
wobei das Buchsenteil (8) mindestens teilweise zwischen dem Rahmen (3) und der internen Komponente (2) in die Richtung der Längsachse (A1) angeordnet ist,
wobei das Buchsenteil (8) eine erste Öffnung (10) umfasst, der Rahmen (3) eine zweite Öffnung (11) umfasst und die Endkappe (6) eine dritte Öffnung (12) umfasst, die erste Öffnung (10), die zweite Öffnung (11), und die dritte Öffnung (12) ausgerichtet und konfiguriert ist, um das Steckteil (9) aufzunehmen,
wobei das Steckteil (9) konfiguriert ist, um mindestens eine von der ersten Öffnung (10), der zweiten Öffnung (11) und der dritten Öffnung (12) in Eingriff zu nehmen, wobei das Steckteil (9) in Bezug auf den Rahmen (3) entlang der Längsachse (A1) fixiert ist,
wobei das Buchsenteil (8) mindestens eine Zunge (8a) umfasst, die konfiguriert ist, um mit einer Oberfläche der internen Komponente (2) in Eingriff zu kommen, wobei die interne Komponente (2) in Bezug auf den Rahmen (3) in mindestens einer Richtung (P1) senkrecht zu der Längsachse (A1) verschiebbar ist,
wobei die Endkappe (6) ein Antennenteil (14) und ein nicht leitfähiges Teil (15) umfasst, wobei das nicht leitfähige Teil (15) das Antennenteil (14) von dem Rahmen (3) trennt,
wobei das Verbindungsmittel (7) leitfähig ist und sich von dem Antennenteil (14) zu der internen Komponente (2) erstreckt.

2. Elektronische Vorrichtung (1) nach Anspruch 1, das zwei Endkappen (6) umfasst, wobei jede Endkappe (6) konfiguriert ist, um eines von zwei offenen Enden (4a, 4b) des Gehäuses (4) in Eingriff zu nehmen,
wobei die Endkappe (6) eine erste Umfangsform (6a) aufweist, die einer Außengrenze des Gehäuses (4) entspricht,
wobei die Endkappe (6) eine zweite Umfangsform (6b) aufweist, die einer Innengrenze des Gehäuses (4) entspricht.

3. Elektronische Vorrichtung (1) nach Anspruch 1 oder 2, die ferner ein Isoliermittel (16), die das Verbindungsmittel (7) mindestens teilweise umschließen, umfassen, wobei das Verbindungsmittel (7) von dem Rahmen (3) isoliert wird.

4. Elektronische Vorrichtung (1) nach einem der vorstehenden Ansprüche, wobei das Steckteil (9) eine Schraube ist und die erste Öffnung (10) des Buchsenteils (8) ein entsprechendes Gewinde umfasst.

5. Elektronische Vorrichtung (1) nach einem der vorstehenden Ansprüche, wobei die Vorrichtung ferner ein Fixierungsmittel (17) zum starren Fixieren der internen Komponente (2) an dem Rahmen (3) umfasst.

6. Elektronische Vorrichtung (1) nach einem der vorstehenden Ansprüche, wobei das Buchsenteil (8) einen blockförmigen Bereich (8b) und einen blattförmigen Bereich (8c) umfasst, wobei sich die erste Öffnung (10) mindestens durch den blockförmigen Bereich (8b) hindurch erstreckt, wobei sich die Zunge (8a) von dem blattförmigen Bereich (8c) erstreckt.

7. Elektronische Vorrichtung (1) nach Anspruch 6,
wobei der blockförmige Bereich (8b) von einer Oberfläche des blattförmigen Bereichs (8c) vorspringt, wobei der blattförmige Bereich (8c) gekrümmt ist, um den blockförmigen Bereich (8b) in einer Richtung (P2), die senkrecht zu einer Mittelachse (A2) der ersten Öffnung (10) ist, teilweise zu umschließen,
wobei sich die mindestens eine Zunge (8a) von einer Kante des blattförmigen Bereichs (8c) in einer Ebene parallel zu der Mittelachse (A2) erstreckt und die mindestens eine Zunge (8a) konfiguriert ist, um an eine erste Oberfläche (2a) der internen Komponente (2) anzustoßen.

8. Elektronische Vorrichtung (1) nach Anspruch 7, wobei der blattförmige Bereich (8c) zwei Zungen (8a) umfasst, die sich auf gegenüberliegenden Seiten der ersten Öffnung (10) in einer Richtung weg von der ersten Öffnung (10) erstrecken.

9. Elektronische Vorrichtung (1) nach Anspruch 8,
wobei der blockförmige Bereich (8b) aus einer Oberfläche des blattförmigen Bereichs (8c) vorspringt, wobei sich die Zunge (8a) von einer Kante des blattförmigen Bereichs (8c) angrenzend an einer Seitenwand des blockförmigen Bereichs (8b) erstreckt,
wobei sich die Seitenwand senkrecht zu der Oberfläche des blattförmigen Bereichs (8c) erstreckt, wobei die Zunge (8a) konfiguriert ist, um an eine zweite Oberfläche (2b) der internen Komponente (2) zu stoßen.

10. Elektronische Vorrichtung (1) nach einem der vorstehenden Ansprüche, die ferner ein Verriegelungsmittel (18), das konfiguriert ist, um zu verhindern, dass sich das Buchsenteil (8) in Bezug auf den Rahmen (3) als Reaktion auf eine Drehung des Steckteils (9) dreht, umfasst.

11. Elektronische Vorrichtung (1) nach Anspruch 10,
wobei das Verriegelungsmittel (18) einen Verriegelungsvorsprung umfasst, der sich von mindestens einem von dem Buchsenteil (8) und dem Isoliermittel (16) in der Richtung der Mittelachse (A2) der ersten Öffnung (10) in die zweite Öffnung (11) des Rahmens (3) erstreckt,
wobei der Verriegelungsvorsprung (18) eine Umfangsform aufweist, die mindestens teilweise der Form der zweiten Öffnung (11) entspricht.

12. Elektronische Vorrichtung (1) nach Anspruch 10 oder 11,
wobei das Verriegelungsmittel (18) einen Klebstoff umfasst, wobei der Klebstoff den Verriegelungsvorsprung mit der zweiten Öffnung (11) und/oder
den blattförmigen Bereich (8c) des Buchsenteils (8) mit einer Oberfläche (3a, 3b) des Rahmens (3) fest verbindet.

13. Verfahren zum Zusammenbauen einer elektronischen Vorrichtung (1), die eine interne Komponente (2) umfasst,
einen Rahmen (3), der zum Aufnehmen der internen Komponente (2) konfiguriert ist,
ein Gehäuse (4), das eine Anzeige (5) umfasst, wobei das Gehäuse (4) konfiguriert ist, um den Rahmen (3) und die interne Komponente (2) mindestens teilweise zu umschließen, und mindestens eine Endkappe (6) konfiguriert ist, um mit einem offenen Ende (4a, 4b) des Gehäuses (4) in Eingriff zu kommen,
wobei das Verfahren den folgenden Schritt umfasst:
Einpassen eines Buchsenteils (8) von mindestens einem Verbindungsmittel (7a) in eine Aussparung (19a) in einer ersten Kante der internen Komponente (2) und Platzieren und Fixieren von vorspringenden Zungen (8a) des Buchsenteils (8) auf eine Oberfläche (2a), die an die Aussparung (19a) angrenzt, der internen Komponente (2),
Platzieren der internen Komponente (2) in dem Rahmen (3) derart, dass eine erste Öffnung (10a) des Buchsenteils (8) an einer zweiten Öffnung (11a) in dem Rahmen (3) ausgerichtet ist,
Fixieren der internen Komponente (2) an dem Rahmen (3) durch Fixierungsmittel (17),
Einführen des Rahmens (3) in das Gehäuse (4) durch ein erstes offenes Ende (4a) des Gehäuses (4) hindurch,
Platzieren einer ersten Endkappe (6) an dem ersten offenen Ende (4a) oder einem gegenüberliegenden zweiten offenen Ende (4b) des Gehäuses (4) derart, dass eine dritte Öffnung (12a) der Endkappe (6) an der ersten Öffnung (10a) und der zweiten Öffnung (11a) ausgerichtet ist,
aufeinanderfolgendes Einführen eines Steckteils (9) der Verbindungsmittel (7a) in die dritte Öffnung (12a), die zweite Öffnung (11a) und die erste Öffnung (10a), wobei das Steckteil (9) mit der ersten Öffnung (10a) derart sperrt, dass die erste Endkappe (6) mit dem Rahmen (3) fest verbunden ist,
wobei die Endkappe (6) ein Antennenteil (14) und ein nicht leitfähiges Teil (15) umfasst, wobei das nicht leitfähige Teil (15) das Antennenteil (14) von dem Rahmen (3) trennt,
wobei das Verbindungsmittel (7) leitfähig ist und sich von dem Antennenteil (14) zu der internen Komponente (2) erstreckt.

14. Verfahren nach Anspruch 13, das ferner die folgenden Schritte umfasst:
Einpassen eines Buchsenteils (8) von mindestens einem weiteren Verbindungsmittel (7b) in eine Aussparung (19b) in einer zweiten Kante der internen Komponente (2), bevor die interne Komponente (2) in dem Rahmen (3) derart platziert wird, dass eine erste Öffnung (10b) des Buchsenteils (8) an einer zweiten Öffnung (11b) in dem Rahmen (3) ausgerichtet ist,
Platzieren einer zweiten Endkappe (6) an dem zweiten offenen Ende (4b) oder dem ersten offenen Ende (4a) des Gehäuses (4) derart, dass eine dritte Öffnung (12b) der zweiten Endkappe (6) an der ersten Öffnung (10b) und der zweiten Öffnung (11b) ausgerichtet ist,
aufeinanderfolgendes Einführen eines Steckteils (9) der Verbindungsmittel (7b) in die dritte Öffnung (12b), die zweite Öffnung (11b) und die erste Öffnung (10b), wobei das Steckteil (9) mit der ersten Öffnung (10b) derart sperrt, dass die zweite Endkappe (6) mit dem Rahmen (3) fest verbunden ist.

## Revendications

1. Dispositif électronique (1) comprenant
un composant interne (2),
un cadre (3) conçu pour recevoir ledit composant interne (2),
un boîtier (4) comprenant un dispositif d'affichage (5), ledit boîtier (4) renfermant au moins partiellement ledit cadre (3) et ledit composant interne (2) le long d'un axe longitudinal (A1) dudit dispositif électronique (1),
au moins un capuchon d'extrémité (6) conçu pour venir en prise avec une extrémité ouverte (4a, 4b) dudit boîtier (4), ladite extrémité ouverte (4a, 4b) s'étendant perpendiculairement audit axe longitudinal (A1),
un moyen de liaison (7) conçu pour relier ledit capuchon d'extrémité (6) de manière rigide avec ledit cadre (3) et de manière élastique avec ledit composant interne (2),
ledit moyen de liaison (7) comprenant une partie femelle (8) et une partie mâle (9),
ladite partie femelle (8) étant disposée au moins partiellement entre ledit cadre (3) et ledit composant interne (2) dans la direction dudit axe longitudinal (A1),
ladite partie femelle (8) comprenant une première ouverture (10), ledit cadre (3) comprenant une deuxième ouverture (11), et ledit capuchon d'extrémité (6) comprenant une troisième ouverture (12), ladite première ouverture (10), ladite deuxième ouverture (11), et ladite troisième ouverture (12) étant alignées et conçues pour recevoir ladite partie mâle (9),
ladite partie mâle (9) étant conçue pour venir en prise avec ladite première ouverture (10), et/ou ladite deuxième ouverture (11) et/ou ladite troisième ouverture (12), ladite partie mâle (9) étant fixée en position, par rapport audit cadre (3), le long dudit axe longitudinal (A1),
ladite partie femelle (8) comprenant au moins une languette (8a) conçue pour venir en prise avec une surface dudit composant interne (2), ledit composant interne (2) étant déplaçable par rapport audit cadre (3) dans au moins une direction (P1) perpendiculaire audit axe longitudinal (A1),
ledit capuchon d'extrémité (6) comprenant une partie d'antenne (14) et une partie non conductrice (15), ladite partie non conductrice (15) séparant ladite partie d'antenne (14) dudit cadre (3),
ledit moyen de liaison (7) étant conducteur et s'étendant à partir de ladite partie d'antenne (14) audit composant interne (2).

2. Dispositif électronique (1) selon la revendication 1, comprenant deux capuchons d'extrémité (6), chaque capuchon d'extrémité (6) étant conçu pour venir en prise avec l'une de deux extrémités ouvertes (4a, 4b) dudit boîtier (4),
ledit capuchon d'extrémité (6) présentant une première forme périphérique (6a) correspondant à une limite extérieure dudit boîtier (4),
ledit capuchon d'extrémité (6) présentant une seconde forme périphérique (6b) correspondant à une limite intérieure dudit boîtier (4).

3. Dispositif électronique (1) selon la revendication 1 ou 2, comprenant en outre un moyen d'isolation (16) renfermant au moins partiellement ledit moyen de liaison (7), isolant ledit moyen de liaison (7) dudit cadre (3).

4. Dispositif électronique (1) selon l'une quelconque des revendications précédentes, dans lequel ladite partie mâle (9) est une vis et ladite première ouverture (10) de ladite partie femelle (8) comprend un filet de vis correspondant.

5. Dispositif électronique (1) selon l'une quelconque des revendications précédentes, dans lequel ledit dispositif comprend en outre un moyen de fixation (17) pour fixer ledit composant interne (2) de manière rigide audit cadre (3).

6. Dispositif électronique (1) selon l'une quelconque des revendications précédentes, dans lequel ladite partie femelle (8) comprend une section en forme de bloc (8b) et une section en forme de feuille (8c), ladite première ouverture (10) s'étendant au moins à travers ladite section en forme de bloc (8b), ladite languette (8a) s'étendant à partir de ladite section en forme de feuille (8c).

7. Dispositif électronique (1) selon la revendication 6,
dans lequel ladite section en forme de bloc (8b) fait saillie depuis une surface de ladite section en forme de feuille (8c), ladite section en forme de feuille (8c) étant incurvée pour renfermer partiellement ladite section en forme de bloc (8b) dans une direction (P2) perpendiculaire à un axe central (A2) de ladite première ouverture (10),
ladite au moins une languette (8a) s'étendant à partir d'un bord de ladite section en forme de feuille (8c), dans un plan parallèle audit axe central (A2), et ladite au moins une languette (8a) étant conçue pour venir en butée contre une première surface (2a) dudit composant intérieur (2).

8. Dispositif électronique (1) selon la revendication 7, dans lequel ladite section en forme de feuille (8c) comprend deux languettes (8a) s'étendant sur des côtés opposés de ladite première ouverture (10) dans une direction éloignée de ladite première ouverture (10).

9. Dispositif électronique (1) selon la revendication 8,
dans lequel ladite section en forme de bloc (8b) fait saillie depuis une surface de ladite section en forme de feuille (8c), ladite languette (8a) s'étendant à partir d'un bord de ladite section en forme de feuille (8c) adjacent à une paroi latérale de ladite section en forme de bloc (8b),
ladite paroi latérale s'étendant perpendiculairement à ladite surface de ladite section en forme de feuille (8c), ladite languette (8a) étant conçue pour venir en butée contre une seconde surface (2b) dudit composant intérieur (2).

10. Dispositif électronique (1) selon l'une quelconque desdites revendications précédentes, comprenant en outre un moyen de verrouillage (18) conçu pour empêcher ladite partie femelle (8) de tourner par rapport audit cadre (3), en réponse à la rotation de ladite partie mâle (9).

11. Dispositif électronique (1) selon la revendication 10,
dans lequel ledit moyen de verrouillage (18) comprend une saillie de verrouillage, s'étendant à partir de ladite partie femelle (8) et/ou dudit moyen d'isolation (16), dans la direction de l'axe central (A2) de ladite première ouverture (10), dans ladite deuxième ouverture (11) dudit cadre (3),
ladite saillie de verrouillage (18) présentant une forme périphérique correspondant au moins partiellement à la forme de ladite deuxième ouverture (11).

12. Dispositif terminal (1) selon la revendication 10 ou 11,
dans lequel ledit moyen de verrouillage (18) comprend un adhésif, ledit adhésif reliant de manière fixe ladite saillie de verrouillage à ladite sdeuxième ouverture (11) et/ou
ladite section en forme de feuille (8c) de ladite partie femelle (8) sur une surface (3a, 3b) dudit cadre (3).

13. Procédé d'assemblage d'un dispositif électronique (1) comprenant un composant interne (2),
un cadre (3) conçu pour recevoir ledit composant interne (2),
un boîtier (4) comprenant un dispositif d'affichage (5), ledit boîtier (4) étant conçu pour renfermer au moins partiellement ledit cadre (3) et ledit composant interne (2), et au moins un capuchon d'extrémité (6) conçu pour venir en prise avec une extrémité ouverte (4a, 4b) dudit boîtier (4),
ledit procédé comprenant l'étape consistant à :
ajuster une partie femelle (8) d'au moins un moyen de liaison (7a) dans un évidement (19a) dans un premier bord dudit composant interne (2), et placer et fixer des languettes saillantes (8a) de ladite partie femelle (8) sur une surface (2a), adjacente audit évidement (19a), dudit composant interne (2),
placer ledit composant interne (2) dans ledit cadre (3), de telle sorte qu'une première ouverture (10a) de ladite partie femelle (8) s'aligne avec une deuxième ouverture (11a) dans ledit cadre (3),
fixer ledit composant interne (2) audit cadre (3) par un moyen de fixation (17),
insérer ledit cadre (3) dans ledit boîtier (4) à travers une première extrémité ouverte (4a) dudit boîtier (4),
placer un premier capuchon d'extrémité (6) au niveau de ladite première extrémité ouverte (4a), ou une deuxième extrémité ouverte (4b) opposée, dudit boîtier (4), de telle sorte qu'une troisième ouverture (12a) dudit capuchon d'extrémité (6) s'aligne avec ladite première ouverture (10a) et ladite deuxième ouverture (11a),
insérer une partie mâle (9) dudit moyen de liaison (7a) successivement dans ladite troisième ouverture (12a), ladite deuxième ouverture (11a) et ladite première ouverture (10a), ladite partie mâle (9) s'interverrouillant avec ladite première ouverture (10a) de telle sorte que ledit premier capuchon d'extrémité (6) est relié de manière fixe audit cadre (3),
ledit capuchon d'extrémité (6) comprenant une partie d'antenne (14) et une partie non conductrice (15), ladite partie non conductrice (15) séparant ladite partie d'antenne (14) dudit cadre (3),
ledit moyen de liaison (7) étant conducteur et s'étendant à partir de ladite partie d'antenne (14) audit composant interne (2).

14. Procédé selon la revendication 13, comprenant en outre les étapes consistant à :
ajuster une partie femelle (8) d'au moins un moyen de liaison (7b) supplémentaire dans un évidement (19b) dans un second bord dudit composant interne (2), avant de placer ledit composant interne (2) dans ledit cadre (3), de telle sorte qu'une première ouverture (10b) de ladite partie femelle (8) s'aligne avec une deuxième ouverture (11b) dans ledit cadre (3),
placer un second capuchon d'extrémité (6) au niveau de ladite seconde extrémité ouverte (4b) ou de ladite première extrémité ouverte (4a) dudit boîtier (4), de telle sorte qu'une troisième ouverture (12b) dudit second capuchon d'extrémité (6) s'aligne avec ladite première ouverture (10b) et ladite deuxième ouverture (11b),
insérer une partie mâle (9) dudit moyen de liaison (7b) successivement dans ladite troisième ouverture (12b), ladite deuxième ouverture (11b) et ladite première ouverture (10b), ladite partie mâle (9) s'interverrouillant avec ladite première ouverture (10b) de telle sorte que ledit second capuchon d'extrémité (6) est relié de manière fixe audit cadre (3).
